# EUROPEAN PATENT SPECIFICATION

(11) **EP 1 375 925 B1**
(45) Date of publication and mention of the grant of the patent: **29.11.2006**
(21) Application number: 03253621.1
(22) Date of filing: 09.06.2003
(51) Int. Cl.: F04D 29/58, F04D 29/44

(54) **Centrifugal blower with cooling fin**
Kreisellüfter mit Kühlschaufel
Ventilateur avec vanne de refroidissement

(30) Priority: 20.06.2002 JP 2002180245
(43) Date of publication of application: 02.01.2004
(73) Proprietor: Sanden Corporation, Isesaki-shi, Gunma 372-8502 (JP)
(72) Inventor: Kitazume, Michio, c/o Sanden Corporation, Isesaki-shi, Gunma 372-8502 (JP); Ohtsuki, Yutaka, c/o Sanden Corporation, Isesaki-shi, Gunma 372-8502 (JP)
(74) Representative: Haley, Stephen

(56) References cited:
- FR-A- 2 742 813
- US-A- 5 842 840
- US-B1- 6 364 004
- PATENT ABSTRACTS OF JAPAN vol. 2000, no. 08, 6 October 2000 (2000-10-06) & JP 2000 145700 A (DENSO CORP), 26 May 2000 (2000-05-26)

## Description

The present invention relates to a centrifugal blower having a cooling fin for cooling a control device in a scroll.

### Description of the Related Art

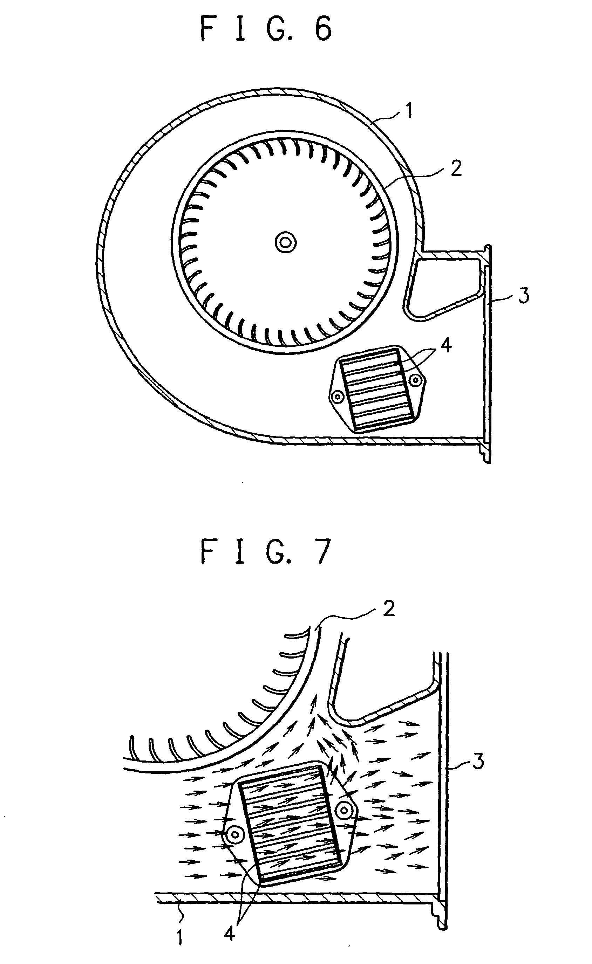

FIG. 6 shows this type of a known centrifugal blower. The centrifugal blower has a multivane impeller 2 in a curved scroll 1. When the impeller 2 is driven by an unshown motor, air is sucked into the impeller 2, flows along the scroll 1, and blown out through a blow port 3. Many cooling fins 4 are provided in a protruding manner near the blow port 3 in the scroll 1, along a flow direction of blown air. An unshown transistor for controlling a motor is cooled via the cooling fins 4.

In this centrifugal blower, however, the blown air is sheared by the cooling fins 4 as shown in FIG. 7 (the arrows show airflow), and a turbulent flow including a Karman vortex occurs on a downstream side of the cooling fins 4. This causes problems that noise is generated in the scroll 1, and the blown air having passed through the cooling fins 4 flows back, and are sucked into the impeller 2 again.

In order to solve the problems, a centrifugal blower is proposed in Japanese Patent Laid-Open No. 2000-145700. In the centrifugal blower, outer cooling fins located on both sides among cooling fins have partitions extending from downstream ends of the outer cooling fins toward a blow port.

In the centrifugal blower, air flows between the cooling fins to form a turbulent flow on a downstream side of the cooling fins, but a flow direction of the blown air is controlled by the partitions to prevent backflow of the air toward an impeller. Thus, low frequency sounds (around 100 Hz) arising from the backflow of the blown air are not amplified.

The centrifugal blower described in Japanese Patent Laid-Open No. 2000-145700 effectively attenuates the low frequency sounds as described above, but attenuates few high frequency sounds, and thus insufficiently attenuates noise of the blower.

In view of the above described problems, an object of the invention is to provide a centrifugal blower that can reliably attenuate high frequency sounds in noise of the blower.

The invention provides a centrifugal blower including: a scroll that accommodates an impeller; and a plurality of cooling fins for cooling a control device that extend near a blow port in the scroll and along an air flow direction, and are provided side by side at intervals in a direction orthogonal to the air flow direction, wherein the centrifugal blower further includes: first straightening vanes that correspond to outer cooling fins located at both ends among the cooling fins, and extend from downstream ends of the outer cooling fins toward the blow port; and a second straightening vane that corresponds to at least one of inner cooling fins located between the outer cooling fins, and extends from a downstream end of an inner cooling fin toward the blow port.

According to the invention, when the impeller is rotated, blown air is sheared by the cooling fins, and blown air flows between the cooling fins. Subsequently, the blown air flows between the first straightening vanes and the second straightening vane, and is then blown out from the blow port.

Between the first straightening vanes according to the invention, at least two passages separated by the second straightening vane are formed, and the blown air flows through each passage. Contrary to this, a centrifugal blower described in Japanese Patent Laid-Open No. 2000-145700 has a single passage between partitions.

With such a difference, the invention achieves an increased straightening effect (a prevention effect of a turbulent flow) on a downstream side of the cooling fins, thus preventing amplification of high frequency sounds resulting from the turbulent flow that occurs on the downstream side of the cooling fins, compared to the blower described in Japanese Patent Laid-Open No. 2000-145700.

Further, even if a turbulent flow including a Karman vortex occurs in one of the passages between the straightening vanes, the turbulent flow has no influence on the blown air passing through the other adjacent passage. In this respect, the invention also achieves reliable attenuation of noise.

The foregoing and other objects, features and advantages of the invention will become more apparent from the following description and the accompanying drawings.
FIG. 1 is a side sectional view of a centrifugal blower according to the invention;
FIG. 2 is a sectional view in an arrow direction taken along the line A-A in FIG. 1;
FIG. 3 is a sectional view in an arrow direction taken along the line B-B in FIG. 1;
FIG. 4 is an enlarged sectional view of action of straightening vanes;
FIG. 5 is a graph of states of noise generation according to presence and absence of the straightening vanes;
FIG. 6 is a side sectional view of a conventional centrifugal blower; and
FIG. 7 is an enlarged sectional view of a state of a turbulent flow of the conventional centrifugal blower having no straightening vane.

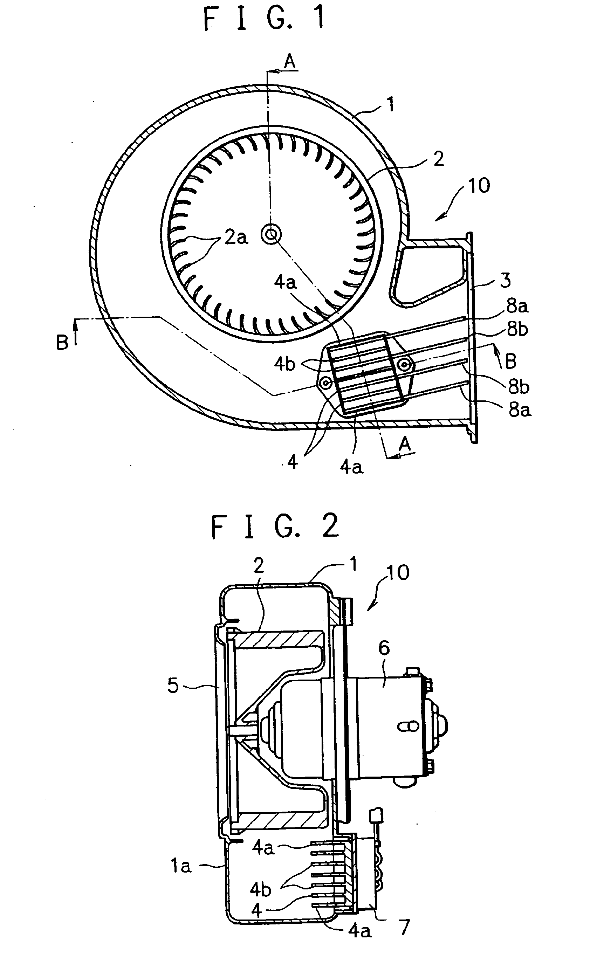

FIGS. 1 to 5 show an embodiment of a centrifugal blower according to the invention. In this embodiment, a multivane blower (hereinafter referred to as a blower) having many forward curved vanes among centrifugal blowers will be described as an example. Parts having like configurations as in a conventional blower in FIGS. 6 and 7 will be described using like reference numerals.

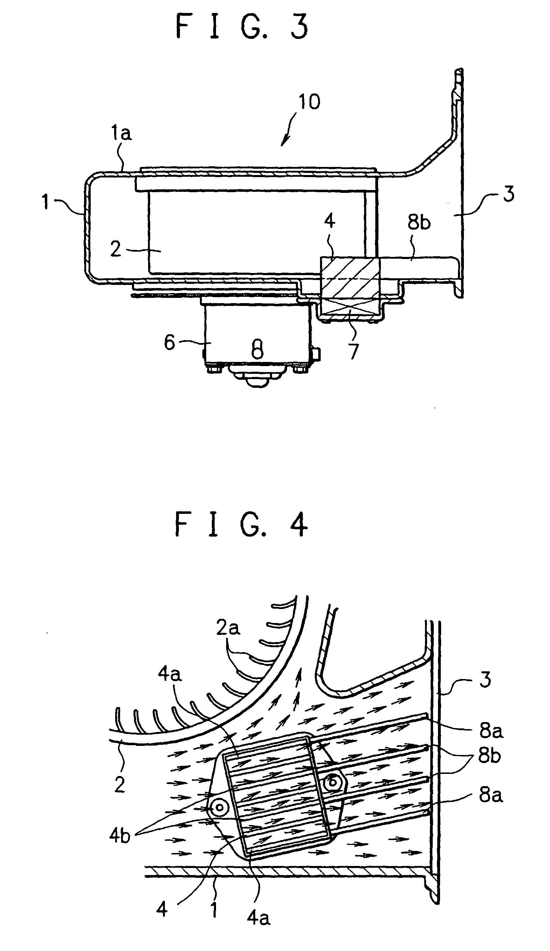

First, a whole structure of a blower 10 will be described with reference to FIGS. 1 to 3. The blower 10 has a scroll 1, and has an impeller 2 with many forward curved vanes 2a therein. A suction port 5 is formed on a side plate 1a of the scroll 1, and air is sucked into the impeller 2 through the suction port 5. A blow port 3 is formed on a blow side of the scroll 1, and the air sucked into the impeller 2 is guided along an inner peripheral surface of the scroll 1, and blown out from the blow port 3. An electric motor 6 is provided as a rotation drive source of the impeller 2 as shown in FIGS. 2 and 3. A control device 7 (such as a transistor) of the electric motor 6 is provided near the blow port 3 in the scroll 1. Seven cooling fins 4 of the transistor 7 protrude inwardly of the scroll 1. Each cooling fin 4 is made of an aluminum material, and extends along a flow direction of blown air flowing in the scroll 1. The cooling fins 4 are provided side by side at intervals in a direction orthogonal to the flow direction of the blown air, allowing the blown air to flow between the cooling fins 4 adjacent to each other.

The above described configuration of the blower 10 is similar to that of the conventional blower, and a feature of the blower 10 according to the invention resides in providing first straightening vanes 8a and second straightening vanes 8b between the cooling fins 4 and the blow port 3.

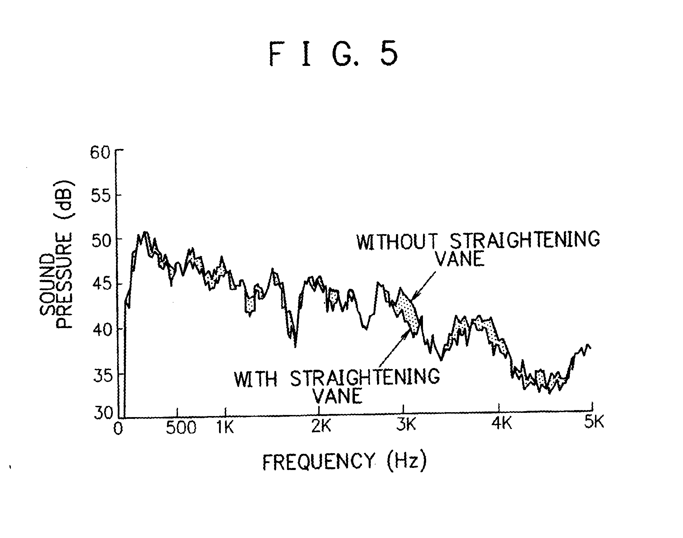

The first straightening vanes 8a correspond to outer cooling fins 4a located at both ends among the cooling fins 4, and extend from downstream ends of the outer cooling fins 4a toward the blow port 3. The second straightening vanes 8b correspond to inner cooling fins 4b located between the outer cooling fins 4a, and extend from downstream ends of the inner cooling fins 4b toward the blow port 3. The straightening vanes 8a, 8b are made of resin and integrally formed with the scroll 1. The straightening vanes 8a, 8b have the same height and width as the cooling fins 4, and extend in the same direction as the cooling fins 4 as shown in FIG. 5 and FIG. 6.

A second straightening vane 8b is arranged at every other inner cooling fin 4b among five inner cooling fins 4b, and this allows the blown air having passed between the cooling fins 4 to be divided into three parts by the straightening vanes 8a, 8b, and blown to the blow port 3.

While the electric motor 6 of the blower 10 according to the embodiment is driven, the impeller 2 rotates, and the air is sucked into the impeller 2 through the suction port 5. Then, the sucked air is blown along the scroll 1 toward the blow port 3. Part of the air blown toward the blow port 3 passes between the cooling fins 4. The blown air having passed through the cooling fins 4 passes through passages divided into three parts, and guided to the blow port 3.

According to the embodiment, the blown air having passed through the cooling fins 4 is divided by the straightening vanes 8a, 8b. Thus, even if a turbulent flow including a Karman vortex occurs in one of the passages, the turbulent flow has no influence on the air passing through the other adjacent passage, preventing amplification of noise resulting from the turbulent flow.

The straightening vanes 8a, 8b have the same height and width as the cooling fins 4, and extend in the same direction as the cooling fins 4, thus there is no bump or flection between the cooling fins 4 and the straightening vanes 8a, 8b. Therefore, the blown air having passed through the cooling fins 4 smoothly flows between the straightening vanes 8a, 8b.

Now, noise attenuation action of the blower 10 will be described with reference to FIG. 5, comparing the conventional blower having no straightening vanes 8a, 8b (the blower in FIGS. 6 and 7) with the blower 10 according to the invention having the straightening vanes 8a, 8b. In FIG. 5, the ordinate axis shows sound pressure, and the abscissa axis shows frequency. The dotted parts in FIG. 5 show the amount of noise attenuation of the blower 10 according to the embodiment.

Specifically, comparing the conventional blower with the blower 10 according to the embodiment, noise is attenuated in most of bands from 500 Hz to 5 kHz in the blower 10, and especially, the amount of attenuation of high frequency sounds of 2 kHz and higher is extremely large.

The straightening vanes 8a, 8b are made of resin and integrally formed with the scroll 1, thus the number of assembly parts is reduced when the blower 10 is produced.

The straightening vane 8 is provided at every other cooling fin 4 in this embodiment, but when the straightening vanes 8a, 8b are arranged correspondingly to all of the cooling fins 4, a straightening effect of the blown air is further increased, and the noise is further attenuated.

## Claims

1. A centrifugal blower comprising:
a scroll (1) that accommodates an impeller (2); and
a plurality of cooling fins (4) for cooling a control device that extend near a blow port (3) in the scroll (1) and along an air flow direction, and are provided side by side at intervals in a direction orthogonal to the air flow direction,
wherein said centrifugal blower further comprises:
first straightening vanes (8a) that correspond to outer cooling fins 4a located at both ends among said cooling fins (4), and extend from downstream ends of said outer cooling fins toward said blow port (3); and wherein said centrifugal blower in **characterized by** comprising
a second straightening vane (8b) in correspondence to at least one of the inner cooling fins (4b) located between said outer cooling fins (4a), and extends from a downstream end of said inner cooling fin toward said blow port (3).

2. The centrifugal blower according to claim 1, wherein said second straightening vane (8b) is provided at every other inner cooling fin (4b) among said plurality of inner cooling fins (4b).

3. The centrifugal blower according to claim 1, wherein said second straightening vane (8b) is provided at each of said plurality of inner cooling fins (4b).

4. The centrifugal blower according to claim 2, wherein said first straightening vanes (8a) and said second straightening vane (8b) have the same height and width as said cooling fins (4), and extend in the same direction as said cooling fins (4).

5. The centrifugal blower according to claim 3, wherein said first straightening vanes (8a) and said second straightening vane (8b) have the same height and width as said cooling fins (4), and extend in the same direction as said cooling fins (4).

6. The centrifugal blower according to any one of claims 1 to 5, wherein said first straightening vane (8a) and said second straightening vane (8b) are integrally formed with said scroll (1).

## Patentansprüche

1. Ein Kreisellüfter, umfassend:
ein Spiralgehäuse (1), welches ein Flügelrad (2) aufnimmt; und
eine Vielzahl von Kühlschaufeln (4) zum Kühlen einer Steuervorrichtung, welche sich nahe eines Ausblasanschlusses (3) in dem Spiralgehäuse (1) und entlang einer Luftstromrichtung erstrecken, und welche in Abständen voneinander Seite an Seite in einer Richtung senkrecht zur Luftstromrichtung angeordnet sind;
wobei der Kreisellüfter ferner umfasst:
erste strombegradigende Rippen (8a), welche äußeren Kühlschaufeln (4a) zugeordnet sind, die sich unter den Kühlschaufeln (4) an deren beiden Enden befinden, und welche sich von dem stromabwärts gerichteten Ende der äußeren Kühlschaufeln ausgehend in Richtung auf den Ausblasanschluss erstrecken und
wobei der Kreisellüfter **dadurch gekennzeichnet ist, dass** er weiter umfasst:
eine zweite strombegradigende Rippe (8b), welche wenigstens einer der inneren Kühlschaufeln (4b) zugeordnet ist, die sich zwischen den äußeren Kühlschaufeln (4a) befinden, und welche sich ausgehend von der inneren Kühlschaufel in Richtung auf den Ausblasanschluss (3) erstreckt.

2. Der Kreisellüfter gemäß Anspruch 1, bei dem die zweite strombegradigende Rippe (8b) an jeder anderen inneren Kühlschaufel (4b) unter der Vielzahl von inneren Kühlschaufeln (4b) vorgesehen ist.

3. Der Kreisellüfter nach Anspruch 1, bei dem die zweite strombegradigende Rippe (8b) bei jeder der Vielzahl von inneren Kühlschaufeln (4b) vorgesehen ist.

4. Der Kreisellüfter nach Anspruch 2, bei dem die ersten strombegradigenden Rippen (8a) sowie die zweite strombegradigende Rippe (8b) die gleiche Höhe und Breite wie die Kühlschaufeln (4) aufweisen und sich in der gleichen Richtung erstrecken wie die Kühlschaufeln (4).

5. Der Kreisellüfter nach Anspruch 3, bei dem die ersten strombegradigenden Rippen (8a) sowie die zweite strombegradigende Rippe (8b) die gleiche Höhe und Breite wie die Kühlschaufeln (4) aufweisen und sich in der gleichen Richtung erstrecken wie die Kühlschaufeln (4).

6. Der Kreisellüfter nach einem der Ansprüche 1 bis 5, bei dem die ersten strombegradigenden Rippen (8a) sowie die zweite strombegradigende Rippe (8b) integral mit Spiralgehäuse (1) ausgebildet sind.

## Revendications

1. Ventilateur centrifuge comprenant :
- une spirale (1) qui reçoit une roue (2),
- une pluralité d'ailettes de refroidissement (4) destinées à refroidir un dispositif de commande s'étendant à côté d'un orifice de soufflage (3) dans la spirale (1), le long d'une direction d'écoulement de l'air, ces ailettes (4) étant disposées côte à côte selon un intervalle régulier dans une direction orthogonale à la direction d'écoulement de l'air
**caractérisé par**
des premières aubes de redressement (8b) qui correspondent aux ailettes de refroidissement externes (4a) situées aux deux extrémités parmi les ailettes de refroidissement (4) et s'étendent depuis les extrémités en aval des ailettes de refroidissement externes (4a) vers l'orifice de soufflage (3),
des deuxièmes aubes de redressement (8b) qui correspondent aux ailettes de refroidissement internes (4b) situées entre les ailettes de refroidissement externes (4a) et s'étendent depuis les extrémités en aval des ailettes de refroidissement internes (4b) vers l'orifice de soufflage (3).

2. Ventilateur centrifuge selon la revendication 1,
**caractérisé en ce que**
la deuxième aube de redressement (8b) est prévue au niveau d'une ailette de refroidissement interne (4b) sur deux, parmi la pluralité d'ailettes de refroidissement internes (4b).

3. Ventilateur centrifuge selon la revendication 1,
**caractérisé en ce que**
la deuxième aube de redressement (8b) est prévue au niveau de la pluralité d'ailettes de refroidissement internes (4b).

4. Ventilateur centrifuge selon la revendication 2,
**caractérisé en ce que**
les premières aubes de redressement (8a) et la deuxième aube de redressement (8b) ont la même hauteur et la même largeur que les ailettes de refroidissement (4) et s'étendent dans la même direction que ces ailettes de refroidissement (4).

5. Ventilateur centrifuge selon la revendication 3,
**caractérisé en ce que**
les premières aubes de redressement (8a) et la deuxième aube de redressement (8b) ont la même hauteur et la même largeur que les ailettes de refroidissement (4) et s'étendent dans la même direction que ces ailettes de refroidissement (4).

6. Ventilateur centrifuge selon l'une des revendications 1 à 5,
**caractérisé en ce que**
la première aube de redressement (8a) et les deuxièmes aubes de redressement (8b) sont formées d'une seule pièce avec la spirale (1).
